# EUROPÄISCHE PATENTSCHRIFT

(11) **EP 3 186 596 B1**
(45) Veröffentlichungstag und Bekanntmachung des Hinweises auf die Patenterteilung: **17.06.2020**
(21) Anmeldenummer: 15734137.1
(22) Anmeldetag: 02.07.2015
(51) Int. Cl.: G01F 1/56, G01F 1/74, G01N 24/08, G01R 33/44, G01F 1/716, G01R 33/50, G01R 33/563

(54) **VERFAHREN ZUM BETREIBEN EINES KERNMAGNETISCHEN DURCHFLUSSMESSGERÄTS UND KERNMAGNETISCHES DURCHFLUSSMESSGERÄT**
METHOD FOR OPERATING A NUCLEAR MAGNETIC FLOWMETER AND NUCLEAR MAGNETIC FLOWMETER
PROCÉDÉ D'UTILISATION D'UN DÉBITMÈTRE MAGNÉTIQUE NUCLÉAIRE ET DÉBITMÈTRE ÉLECTROMAGNÉTIQUE NUCLÉAIRE

(30) Priorität: 29.08.2014 DE 102014012574; 02.02.2015 DE 102015001161
(43) Veröffentlichungstag der Anmeldung: 05.07.2017
(73) Patentinhaber: Krohne AG, 4019 Basel (CH)
(72) Erfinder: HOGENDOORN, Cornelis Johannes, NL-4211 BG Spijk (NL); CERIONI, Lucas Matias Ceferino, NL-3311 GN Dordrecht (NL); TROMP, Rutger Reinout, NL-3311 EM Dordrecht (NL); ZOETEWEIJ, Marco Leendert, NL-3344 EP Hendrik-Ido-Ambach (NL); BOUSCHÉ, Olaf Jean Paul, NL-3319 PH Dordrecht (NL)
(74) Vertreter: Gesthuysen Patent- und Rechtsanwälte
(86) Internationale Anmeldenummer: PCT/EP2015/065138
(87) Internationale Veröffentlichungsnummer: WO 2016/030059

(56) Entgegenhaltungen:
- WO-A1-91/18280
- DE-A1- 4 119 711
- GB-A- 2 342 170
- GB-A- 2 432 003
- US-A- 4 769 602
- US-A1- 2008 174 309
- US-A1- 2012 092 007
- DYAKOWSKI T ET AL: "Process tomography applied to multi-phase flow measurement", MEASUREMENT SCIENCE AND TECHNOLOGY, IOP, BRISTOL, GB, Bd. 7, Nr. 3, 1. März 1996 (1996-03-01), Seiten 343-353, XP020063986, ISSN: 0957-0233, DOI: 10.1088/0957-0233/7/3/015
- N. REINECKE ET AL: "Tomographic imaging of the phase distribution in two-phase slug flow", INTERNATIONAL JOURNAL OF MULTIPHASE FLOW., Bd. 24, Nr. 4, 31. Dezember 1996 (1996-12-31), Seiten 617-634, XP055247195, NL ISSN: 0301-9322, DOI: 10.1016/S0301-9322(97)00060-8

## Beschreibung

Die Erfindung betrifft zunächst Verfahren zur Bestimmung des Durchflusses eines durch ein Messrohr strömenden mehrphasigen Mediums mit einem kernmagnetischen Durchflussmessgerät, mit einer Vormagnetisierungseinrichtung und mit einer Messeinrichtung, wobei die Vormagnetisierungseinrichtung mindestens zwei unterschiedlich lange Vormagnetisierungsstrecken der Längen L₁, L₂, ... realisiert. Ferner betrifft die Erfindung auch ein kernmagnetisches Durchflussmessgerät, insbesondere zur Anwendung bei erfindungsgemäßen Verfahren.

Kernmagnetische Durchflussmessgeräte, die also zur Bestimmung des Durchflusses eines durch ein Messrohr strömenden Mediums ausgebildet sind, werden insbesondere dann eingesetzt, wenn das Medium mehrere Phasen beinhaltet. Die Bestimmung des Durchflusses eines mehrphasigen Mediums umfasst neben der Bestimmung der Strömungsgeschwindigkeit und der Durchflussrate ebenfalls die Bestimmung der Anteile der einzelnen Phasen an dem Medium. Jedoch ist auch die Bestimmung des Durchflusses eines einphasigen Mediums mit einem kernmagnetischen Durchflussmessgerät möglich.

Grundvoraussetzung für die Anwendbarkeit kernmagnetischer Messmethoden ist, dass das Medium oder jede Phase des Mediums Atomkerne mit magnetischen Momenten aufweist.

Zur Unterscheidung der einzelnen Phasen ist es zudem nötig, dass die einzelnen Phasen unterscheidbare Relaxationszeiten besitzen. Von besonderer Bedeutung ist vorliegend die sogenannte Spin-Gitter-Relaxationszeit T₁, auch mit T₁-Zeit bezeichnet.

Befindet sich ein System, bestehend aus ein magnetisches Moment tragenden Atomkernen in einem externen, eine bestimmte Richtung aufweisenden Magnetfeld, so richten sich die magnetischen Momente der Atomkerne in dem externen Magnetfeld aus. Die magnetischen Momente nehmen einen Zustand parallel oder antiparallel zu dem äußeren Magnetfeld ein, wobei der Zustand parallel zum äußeren Magnetfeld mit einer höheren Wahrscheinlichkeit besetzt wird, so dass sich in dem System eine "Netto-Magnetisierung" parallel zum äußeren Feld ausbildet. Diese "Netto-Magnetisierung" wird auch als Gleichgewichtsmagnetisierung bezeichnet. Durch einen äußeren Störeinfluss kann die Magnetisierung aus ihrer Gleichgewichtslage ausgelenkt werden. Sobald der Störeinfluss jedoch wegfällt, ist die Magnetisierung bestrebt, ihre Gleichgewichtslage wieder einzunehmen, wieder in ihre Gleichgewichtslage zu relaxieren. Die Zeit, die dafür benötigt wird, ist die Spin-Gitter-Relaxationszeit T₁.

Die Spin-Gitter-Relaxationszeit T₁ weist für jede Phase in einem mehrphasigen Medium einen unterschiedlichen Wert auf, wie bereits oben ausgeführt. Demnach ist die T₁-Zeit auch ein wichtiger kennzeichnender und charakterisierender Parameter einer jeden Phase. Insbesondere ermöglicht die Kenntnis der T₁-Zeit eine gute Grundlage zur vollständigen Charakterisierung des Mediums. Die Bestimmung der T₁-Zeit erweist sich häufig als relativ kompliziert und vor allem sehr zeitaufwendig.

Hier sei darauf hingewiesen, dass aus Ölquellen geförderte mehrphasige Medium im Wesentlichen aus den beiden flüssigen Phasen Rohöl und Salzwasser und der gasförmigen Phase Erdgas besteht, wobei alle drei Phasen Wasserstoffkerne enthalten, die ein magnetisches Moment tragen.

Aus dem Stand der Technik bekannte kernmagnetische Durchflussmessgeräte, die zur Bestimmung des Durchflusses eines durch ein Messrohr strömenden mehrphasigen Mediums verwendet werden, können so ausgelegt sein, dass sie mitunter eine Vormagnetisierungseinrichtung und eine Messeinrichtung beinhalten, wobei die Vormagnetisierungseinrichtung mindestens zwei unterschiedlich lange Vormagnetisierungsstrecken der Längen L₁, L₂ ... realisiert.

Aus der US 2012/092007 A1 ist ein Verfahren zur Bestimmung der Durchflussrate einer Phase eines mehrphasigen Mediums bekannt. Ebenfalls bekannt ist eine entsprechende Vorrichtung. Das Medium wird mittels zweier unterschiedlich langer Vormagnetisierungsstrecken vormagnetisiert und anhand einer gemessenen Magnetisierung wird auf die relativen Anteile zweier Phasen des Mediums rückgeschlossen.

Aus der US 2008/0174309 A1 ist ein Verfahren zur Bestimmung des Durchflusses eines mehrphasigen Mediums bekannt. Um ein zweidimensionales Geschwindigkeitsprofil des mehrphasigen Mediums zu erzeugen, werden kernmagnetische Messungen durchgeführt. Hierzu wird eine Schichtung in zwei verschiedenen Richtungen realisiert.

Aufgabe der vorliegenden Erfindung ist es, Verfahren zum Betreiben eines kernmagnetischen Durchflussmessgerätes anzugeben, mit denen auf gegenüber dem Stand der Technik vereinfachte Weise der Durchfluss eines mehrphasigen Mediums bestimmt werden kann.

Ein erstes erfindungsgemäßes Verfahren ist dadurch gekennzeichnet, dass eine Messeinrichtung verwendet wird, die am Ende einer jeden Vormagnetisierungsstrecke 2D-Tomographie in einer Messebene senkrecht zur Messrohrlängsachse realisiert, dass die Messebenen jeweils identisch in Voxel unterteilt sind, dass die Größe der Voxel derart gewählt wird, dass in jedem Voxel nur eine Phase des Mediums strömt, dass zur Bestimmung von Messsignalen eine kernmagnetische Messung durchgeführt wird, dass die Strömungsgeschwindigkeit des Mediums in jedem Voxel in einer Messebene ermittelt wird, dass aus den ermittelten Werten der Strömungsgeschwindigkeiten der jeweils korrespondierenden Voxel der einzelnen Messebenen die mittlere Strömungsgeschwindigkeit des Mediums jeweils eines Voxels über alle Messebenen bestimmt wird, dass das Signalverhältnis der Messsignale jeweils korrespondierender Voxel der verschiedenen Messebenen zueinander bestimmt wird und dass mit den bekannten Werten für die Längen L₁, L₂ ... der Vormagnetisierungsstrecken die T₁-Zeiten in jedem Voxel aus den Signalverhältnissen bestimmt werden.

Eine bevorzugte Ausführungsform des erfindungsgemäßen Verfahrens ist dadurch gekennzeichnet, dass in einem weiteren, insbesondere einem anschließenden Schritt mit den jeweiligen T₁-Zeiten der jeweilige Wasserstoffindex in jedem Voxel ermittelt wird und dass anhand der T₁-Zeiten und der Wasserstoffindizes HI die verschiedenen Phasen des Mediums und die Bereiche der verschiedenen Phasen bestimmt werden.

Eine weitere bevorzugte Ausführungsform des erfindungsgemäßen Verfahrens ist dadurch gekennzeichnet, dass in einem anschließenden Verfahrensschritt die Durchflussraten durch Integration über die verschiedenen Bereiche des Mediums und Multiplikation mit den entsprechenden Strömungsgeschwindigkeiten bestimmt werden. Diese Ausführungsform weist den großen Vorteil auf, dass die Durchflussraten der einzelnen Phasen des Mediums lediglich durch die Kenntnis der "Ausdehnung der Bereiche der einzelnen Phasen" und die entsprechenden Strömungsgeschwindigkeiten bestimmt werden können.

Eine besonders bevorzugte Ausführungsform des erfindungsgemäßen Verfahrens ist dadurch gekennzeichnet, dass die kernmagnetische Messung mit einer CPMG-Sequenz realisiert ist. Es ist jedoch festzuhalten, dass jede für kernmagnetische Messungen verwendbare Pulssequenz verwendet werden kann.

Die Geschwindigkeit des Mediums in einem jeden Voxel kann in einer Ausführungsform des erfindungsgemäßen Verfahrens durch die "Convective-Decay"-Methode bestimmt werden. Bei dieser Methode wird das Medium auf der Messstrecke in der Messeinrichtung angeregt und die von dem angeregten Medium ausgesendeten Messsignale mehrmals hintereinander gemessen. Da der angeregte Bereich nach und nach aus der Messstrecke in der Messeinrichtung fließt, also die Anzahl der sich in dem Messbereich befindlichen angeregten Kernspins sinkt, wird das Messsignal mit jedem Messvorgang schwächer. Anhand der Abnahme der Signalstärke kann die Strömungsgeschwindigkeit bestimmt werden.

Eine weitere bevorzugte Ausführungsform des erfindungsgemäßen Verfahrens ist dadurch gekennzeichnet, dass für die Bestimmung der Signalverhältnisse die Amplituden der Messsignale zur Zeit t = 0 benutzt werden. Hierbei ist die Zeit t = 0 definiert als der Anfang der Messung.

Eine besondere Ausführungsform des erfindungsgemäßen Verfahrens ist dadurch gekennzeichnet, dass für die Bestimmung des Signalverhältnisses der zeitliche Verlauf der Messsignale benutzt wird. Das ist möglich, da zum einen in jedem Voxel das Medium in einem einphasigen Zustand ist, also jeweils nur eine einzige Phase des Mediums in einem Voxel auftritt, weil dann die von der Phase des Mediums abhängigen Spin-Spin-Relaxationszeiten T₂ in den jeweils korrespondierenden Voxeln der verschiedenen Messebenen identisch sind, und zum anderen die Geschwindigkeiten des Mediums in den jeweils korrespondierenden Voxeln der verschiedenen Messebenen als identisch angenommen werden können.

Eine auch bevorzugte Ausführungsform des erfindungsgemäßen Verfahrens ist dadurch gekennzeichnet, dass die mindestens zwei Vormagnetisierungsstrecken durch rotierende Magnetanordnungen realisiert sind und dass die Messebenen am Ende der jeweiligen Vormagnetisierungsstrecken in einer einzigen räumlichen Ebene realisiert sind. Demnach können die mindestens zwei Messebenen am Ende der jeweiligen Vormagnetisierungsstrecken räumlich zusammenfallen. Durch diese erfindungsgemäße Ausführungsform lässt sich ein einfacher Aufbau der Messeinrichtung realisieren.

Bei einer weiteren Ausführungsform ist vorgesehen, dass die mindestens zwei Vormagnetisierungsstrecken durch Zerstörungspulse aussendende RF-Spulen realisiert sind und dass die Messebenen am Ende der jeweiligen Vormagnetisierungsstrecken in einer einzigen räumlichen Ebene realisiert sind. Als ein Zerstörungspuls wird hier ein Puls oder eine Pulssequenz bezeichnet, der oder die die Magnetisierung des Mediums in z-Richtung zerstört bzw. zerstören. Die die Zerstörungspulse aussendenden RF-Spulen sind im Bereich der Vormagnetisierungseinheit angeordnet. Jede der RF-Spulen definiert den Anfang einer Vormagnetisierungsstrecke, da sich die Magnetisierung nach der Zerstörung wieder aufbaut, so als ob das Medium in die Vormagnetisierungseinheit einströmt. Diese Ausführungsform weist ebenfalls den Vorteil auf, dass die mindestens zwei Messebenen am Ende der jeweiligen Vormagnetisierungsstrecken räumlich zusammenfallen.

Die oben aufgezeigte Aufgabe wird ferner dadurch gelöst, dass ein Verfahren zur Bestimmung des Durchflusses eines durch ein Messrohr strömenden mehrphasigen Mediums mit einem kernmagnetischen Durchflussmessgerät mit einer Vormagnetisierungseinrichtung und mit einer Messeinrichtung, wobei die Vormagnetisierungseinrichtung mindestens zwei unterschiedlich lange Vormagnetisierungsstrecken der Längen L₁, L₂, ... realisiert, angewendet wird, dass dadurch gekennzeichnet ist, dass eine Messeinrichtung verwendet wird, die am Ende einer jeden Vormagnetisierungsstrecke 2D-Tomographie in der Messrohrquerschnittsebene mit Schichtung in z-Richtung realisiert, dass die Messrohrquerschnittsebene in im Verhältnis zum Messrohrdurchmesser dünne Schichten aufgeteilt wird, dass in jeder Schicht kernmagnetische Messungen zur Bestimmung von Messsignalen mit mindestens zwei verschieden langen Vormagnetisierungsstrecken durchgeführt werden, dass aus den Messsignalen die Durchflussgeschwindigkeiten in jeder einzelnen Schicht bestimmt werden und dass aus den Signalverhältnissen der Amplituden der Messsignale in jeder Schicht die T₁-Zeit bestimmt wird.

Eine besondere Ausführungsform des zuletzt beschriebenen erfindungsgemäßen Verfahrens ist dadurch gekennzeichnet, dass mit den absoluten Amplituden der Messsignale die Anteile der einzelnen Phasen im Medium bestimmt werden.

Das zuletzt beschriebene erfindungsgemäße Verfahren eignet sich insbesondere für die Durchflussmessung an mehrphasigen Medien, bei denen die einzelnen Phasen des Mediums unterschiedliche Durchflussgeschwindigkeiten aufweisen. In einem solchen Fall kann es dazu kommen, dass eine schneller strömende Phase eine langsamer strömende Phase überholt, man spricht von sogenanntem "phase slip". Bei einer Vernachlässigung der unterschiedlichen Durchflussgeschwindigkeiten, also der Annahme einer einzigen Durchflussgeschwindigkeit des Mediums kommt es zu Ungenauigkeiten und Messfehlern. Dadurch, dass die Schichten, in denen die Messungen durchgeführt werden, dünn im Verhältnis zum Messrohrquerschnitt gewählt werden, ist die Annahme gerechtfertigt, dass jede Schicht nur eine einzige Phase enthält, also ein phase slip innerhalb einer Schicht nicht auftritt.

Ein weiteres Problem bei der Durchflussmessung an mehrphasigen Medien ist in der Schwierigkeit der Messung des Gasanteils begründet, da Gas ein sehr geringes Messsignal aufweist. Demnach ist eine weitere bevorzugte Ausgestaltung des erfindungsgemäßen Verfahrens, die sich insbesondere für solche Medien als vorteilhaft erweist, die Schwallströmung oder ein geschichtetes Strömungsprofil aufweisen, dadurch gekennzeichnet, dass das Wasser-zu-Flüssigkeitsverhältnis für die unteren Schichten im Messrohr schichtweise von unten nach oben im Messrohr bestimmt wird, dass aus den bestimmten Werten eine Wasser-zu-Flüssigkeitsverhältnis-Kurve in Abhängigkeit der Position der Schichten im Messrohr generiert wird, dass die Kurve ausgehend von dem letzten bestimmten Wert über den gesamten Messrohrquerschnitt extrapoliert wird, dass aus der extrapolierten Kurve die erwarteten Messsignalamplituden für die oberen Schichten in Messrohr berechnet werden und dass der Gas-Volumen-Anteil in den oberen Schichten bestimmt wird aus der Differenz zwischen der erwarteten Messsignalamplitude und der tatsächlich gemessenen Messsignalamplitude.

In den Schichten im unteren Bereich des Messrohres befindet sich bei Schwallströmung oder bei einer geschichteten Strömung kein Gas. Demnach ist das Signal einzig durch den flüssigen Anteil des Mediums bestimmt, es gilt α_{O} + α_{W} = 1. Demnach ist es möglich, die absoluten Amplituden zur Bestimmung der Anteile der Phasen am Medium zu verwenden und insbesondere das Wasser-zu-Flüssigkeitsverhältnis zu bestimmen. Hierbei ist das Signal von Öl stärker als das Signal von Wasser. Ein größeres Wasser-zu-Flüssigkeits-verhältnis korrespondiert also zu einem schwächeren Messsignal (unter der Voraussetzung, dass α_{O} + α_{W} = 1). In den Schichten im oberen Bereich des Messrohrs hingegen befindet sich mit aller Wahrscheinlichkeit Gas. Da Gas ein sehr schwaches Messsignal aufweist, wird das Gesamtsignal in gashaltigen Schichten im Vergleich zu gasfreien Schichten ebenfalls schwach sein. Ein schwaches Messsignal korrespondiert mit einer kleinen Messsignalamplitude, wohingegen ein starkes Messsignal mit einer großen Messsignalamplitude korrespondiert. Aus dem theoretisch berechneten Messsignalamplituden unter der Annahme, dass auch in den oberen Schichten kein Gas auftritt, und der tatsächlich gemessenen Messsignalamplitude lässt sich dann nach der 1-α-Methode der Gasanteil des Mediums berechnen, indem die tatsächlich gemessene Messsignalamplitude von dem theoretisch berechneten Messsignalampli-tude subtrahiert wird.

Im Übrigen ist es auch Aufgabe der Erfindung, ein kernmagnetisches Durchflussmessgerät anzugeben, mit dem auf vereinfachte Weise der Durchfluss eines mehrphasigen Mediums bestimmt werden kann.

Die zuvor aufgezeigte Aufgabe ist zunächst und im Wesentlichen dadurch gelöst, dass die Messeinrichtung am Ende einer jeden Vormagnetisierungsstrecke 2D-Tomographie in einer Messebene senkrecht zur Messrohrlängsachse realisiert oder 2D-Tomographie in der Messrohrquerschnittsebene mit Schichtung in z-Richtung realisiert.

In dem erfindungsgemäßen kernmagnetischen Durchflussmessgerät sind also mindestens zwei unterschiedlich lange Vormagnetisierungsstrecken vorgesehen, demnach sind erfindungsgemäß auch mindestens zwei Messebenen vorgesehen. Insbesondere kann auch eine größere Anzahl als zwei Vormagnetisierungsstrecken und Messebenen vorgesehen sein.

Eine besondere Ausführungsform des erfindungsgemäßen Durchflussmessgerätes ist dadurch gekennzeichnet, dass die unterschiedlichen Längen L₁, L₂ ... der Vormagnetisierungsstrecken durch variable RF-Spulen realisiert sind und dass die Messebenen am Ende einer jeden Vormagnetisierungsstrecke in den Bereich der jeweiligen RF-Spule fallen.

Eine weitere Ausführungsform ist dadurch gekennzeichnet, dass die unterschiedlichen Längen L₁, L₂ ... der Vormagnetisierungsstrecken durch rotierende Magneteinheiten realisiert sind und dass die Messebenen am Ende einer jeden Vormagnetisierungsstrecke in eine einzige räumliche Ebene fallen.

Eine bevorzugte Ausführungsform des kernmagnetischen Durchflussmessgerätes, ist dadurch gekennzeichnet, dass die unterschiedlichen Längen L₁, L₂ ... der Vormagnetisierungsstrecken durch Zerstörungspulse aussendende RF-Spulen realisiert sind und dass die Messebenen am Ende einer jeden Vormagnetisierungsstrecke in eine einzige räumliche Ebene fallen.

Im Einzelnen gibt es nun eine Vielzahl von Möglichkeiten, das erfindungsgemäße kernmagnetische Durchflussmessgerät auszugestalten und weiterzubilden. Dazu wird verwiesen auf die dem Patentanspruch 14 nachgeordneten Patentansprüche sowie auf die Beschreibung in Verbindung mit der Zeichnung. In der Zeichnung zeigen:
- Fig. 1: eine schematische Darstellung eines ersten bevorzugten Ausführungsbeispiels des erfindungsgemäßen kernmagnetischen Durchflussmessgeräts,
- Fig. 2: eine schematische Darstellung eines zweiten bevorzugten Ausführungsbeispiels des erfindungsgemäßen kernmagnetischen Durchflussmessgeräts,
- Fig. 3: eine schematische Darstellung eines dritten bevorzugten Ausführungsbeispiels des erfindungsgemäßen kernmagnetischen Durchflussmessgeräts.

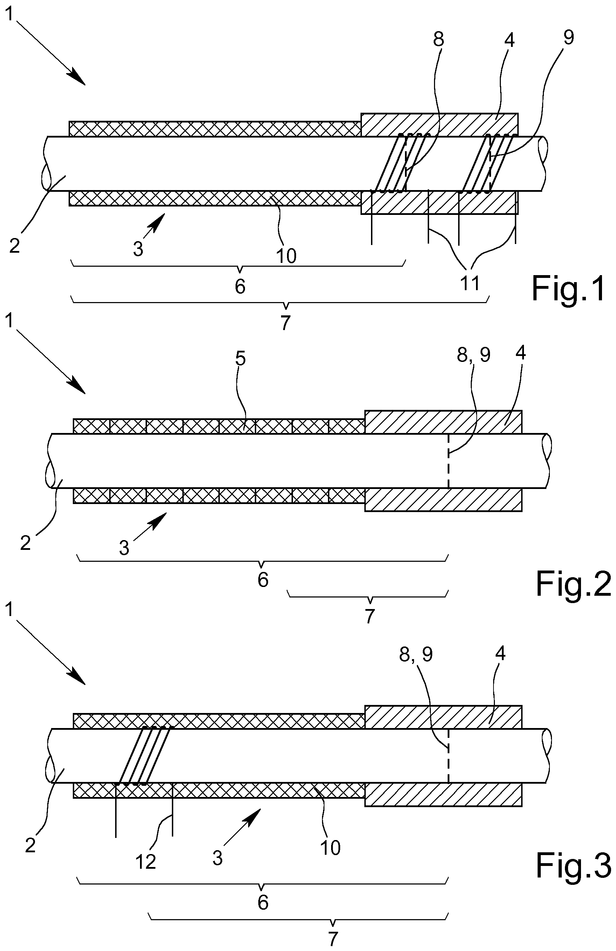

In Fig. 1 ist ein erstes Ausführungsbeispiel des erfindungsgemäßen kernmagnetischen Durchflussmessgeräts 1 schematisch dargestellt. Das Medium, dessen Durchfluss bestimmt werden soll, fließt durch das Messrohr 2. Das Durchflussmessgerät 1 umfasst eine Vormagnetisierungseinrichtung 3, wobei die Vormagnetisierungseinrichtung 3 einen oder mehrere Permanentmagnete 10 zur Erzeugung eines das Messrohr 2 durchsetzenden Magnetfeldes umfasst, sowie eine Messeinrichtung 4. Im Bereich der Messeinrichtung 4 sind zwei variable RF-Spulen 11 angeordnet. Die variablen RF-Spulen 11 dienen zur Anregung des Mediums mit Anregungssignalen und zum Empfangen von vom Medium aufgrund der Anregungssignale ausgesendeten Messsignalen. In der ersten variablen RF-Spule 11 befindet sich eine erste Messebene 8, die senkrecht zur Messrohrlängsachse ist. Die erste Vormagnetisierungsstrecke 6 ist demnach definiert als die Strecke von Beginn der Vormagnetisierungseinrichtung 3 bis zur ersten Messebene 8. In der zweiten variablen RF-Spule 11 befindet sich eine zweite Messebene 9, die ebenfalls senkrecht zur Messrohrlängsachse ist. Die zweite Vormagnetisierungsstrecke 7 ist demnach definiert als die Strecke von Beginn der Vormagnetisierungseinrichtung 3 bis zur zweiten Messebene 9. Da die erste Messebene 8 und die zweite Messebene 9 räumlich nicht aufeinander fallen, sind die Längen der ersten Vormagnetisierungsstrecke 6 und der zweiten Vormagnetisierungsstrecke 7 unterschiedlich. In den Messebenen 8 und 9 wird 2D-Tomographie realisiert. Ebenfalls denkbar ist die Realisierung von Tomographie mit Schichtung in z-Richtung.

In Fig. 2 ist ein zweites Ausführungsbeispiel des erfindungsgemäßen kernmagnetischen Durchflussmessgeräts 1 schematisch dargestellt. Im Unterschied zu dem in Fig. 1 dargestellten Ausführungsbeispiel umfasst die Vormagnetisierungseinrichtung 3 eine Mehrzahl von rotierenden Magneteinheiten 5. Dargestellt sind sechs solcher Magneteinheiten 5, jedoch ist die Erfindung nicht auf eine bestimmte Anzahl an Magneteinheiten 5 beschränkt. Jede der Magneteinheiten 5 erzeugt ein Magnetfeld einer bestimmten Stärke und Richtung. Die Magnetfelder benachbarter rotierender Magneteinheiten 5 können parallel oder antiparallel zueinander sein, ebenfalls denkbar ist, dass eine Magneteinheit 5 kein Magnetfeld erzeugt. Durch die Wahl der Orientierung benachbarter Magneteinheiten 5 wird die effektive Vormagnetisierungsstrecke definiert. Dargestellt ist zum einen eine erste Vormagnetisierungsstrecke 6 und zum anderen eine zweite Vormagnetisierungsstrecke 7. Beide Vormagnetisierungsstrecken 6, 7 haben im Gegensatz zu den Vormagnetisierungsstrecken 6, 7 nach dem ersten Ausführungsbeispiel einen unterschiedlichen Startpunkt und einen gemeinsamen Endpunkt. Demnach fallen die erste Messebene 8 und die zweite Messebene 9 in eine räumliche Ebene in der Messeinrichtung 4. In den Messebenen 8 und 9 wird 2D-Tomographie realisiert. Ebenfalls denkbar ist die Realisierung von Tomographie mit Schichtung in z-Richtung.

In Fig. 3 ist ein drittes Ausführungsbeispiel des erfindungsgemäßen Durchflussmessgeräts 1 dargestellt. Durch das Messrohr 2 fließt das Medium, dessen Durchfluss bestimmt werden soll. Das Durchflussmessgerät beinhaltet analog zu den beiden vorher beschriebenen Ausführungsbeispielen eine Vormagnetisierungseinrichtung 3 und eine Messeinrichtung 4. In dem in Fig. 3 dargestellten Ausführungsbeispiel beinhaltet die Vormagnetisierungseinrichtung 3 einen Permanentmagneten 10 oder mehrere Permanentmagnete 10 zur Erzeugung eines das Medium durchsetzenden Magnetfeldes. Ferner beinhaltet die Vormagnetisierungseinrichtung 3 eine einen die Magnetisierung des Mediums zerstörenden Puls oder eine die Magnetisierung des Mediums zerstörende Pulssequenz erzeugende RF-Spule 12. Durch den Zerstörungspuls wird die sich in dem Bereich zwischen Eintritt in die Vormagnetisierungseinrichtung 3 und Zerstörungsspule 12 aufgebaute Magnetisierung wieder zerstört, so dass an der Stelle der Zerstörungsspule 12 der Beginn einer "neuen" Vormagnetisierungsstrecke liegt.

Die zwei verschieden langen Vormagnetisierungsstrecken 6, 7 haben - wie ausgeführt - einen unterschiedlichen Anfang, können also - wie in Fig. 3 dargestellt - ein gleiches Ende haben. In der Messeinrichtung 4 fallen die Messebene 8 und die Messebene 9 in eine einzige räumliche Ebene. In den Messebenen 8 und 9 wird 2D-Tomographie realisiert. Ebenfalls denkbar ist die Realisierung von Tomographie mit Schichtung in z-Richtung.

## Patentansprüche

1. Verfahren zur Bestimmung des Durchflusses eines durch ein Messrohr strömenden mehrphasigen Mediums mit einem kernmagnetischen Durchflussmessgerät, mit einer Vormagnetisierungseinrichtung und mit einer Messeinrichtung, wobei die Vormagnetisierungseinrichtung mindestens zwei unterschiedlich lange Vormagnetisierungsstrecken der Längen L₁, L₂, ... realisiert, wobei zur Bestimmung von Messsignalen eine kernmagnetische Messung durchgeführt wird,
**dadurch gekennzeichnet,**
**dass** eine Messeinrichtung verwendet wird, die am Ende einer jeden Vormagnetisierungsstrecke 2D-Tomographie in einer Messebene senkrecht zur Messrohrlängsachse realisiert,
**dass** die Messebenen jeweils identisch in Voxel unterteilt sind,
**dass** die Größe der Voxel derart gewählt wird, dass in jedem Voxel nur eine Phase des Mediums strömt,
**dass** die Strömungsgeschwindigkeit des Mediums in jedem Voxel in jeder Messebene ermittelt wird,
**dass** aus den ermittelten Werten der Strömungsgeschwindigkeiten der jeweils korrespondierenden Voxel der einzelnen Messebenen die mittlere Strömungsgeschwindigkeit des Mediums jeweils eines Voxels über alle Messebenen bestimmt wird,
**dass** das Signalverhältnis der Messsignale der jeweils korrespondierenden Voxel der verschiedenen Messebenen zueinander bestimmt wird und
**dass** mit den bekannten Werten für die Längen L₁, L₂, ... der Vormagnetisierungsstrecken die T₁-Zeiten in jedem Voxel aus den Signalverhältnissen bestimmt werden.

2. Verfahren nach Anspruch 1, **dadurch gekennzeichnet, dass** mit den jeweiligen T₁-Zeiten der jeweilige Wasserstoffindex HI in jedem Voxel ermittelt wird und dass anhand der T₁-Zeiten und der Wasserstoffindizes HI die verschiedenen Phasen des Mediums und die Bereiche der verschiedenen Phasen bestimmt werden.

3. Verfahren nach Anspruch 2, **dadurch gekennzeichnet, dass** Durchflussraten durch Integration über die verschiedenen Bereiche des Mediums und Multiplikation mit den entsprechenden Strömungsgeschwindigkeiten bestimmt werden.

4. Verfahren nach einem der Ansprüche 1 bis 3, **dadurch gekennzeichnet, dass** die kernmagnetische Messung mit einer CPMG-Sequenz realisiert wird.

5. Verfahren nach einem der Ansprüche 1 bis 4, **dadurch gekennzeichnet, dass** die Geschwindigkeit des Mediums in einem jeden Voxel in jeder Ebene durch die "Convective Decay"- Methode bestimmt wird.

6. Verfahren nach einem der Ansprüche 1 bis 5, **dadurch gekennzeichnet, dass** für die Bestimmung der Signalverhältnisse die Amplituden der Messsignale zur Zeit t = 0 benutzt werden.

7. Verfahren nach einem der Ansprüche 1 bis 5, **dadurch gekennzeichnet, dass** für die Bestimmung der Signalverhältnisse der zeitliche Verlauf der Messsignale benutzt wird.

8. Verfahren nach einem der Ansprüche 1 bis 7, **dadurch gekennzeichnet, dass** die mindestens zwei Vormagnetisierungsstrecken durch rotierende Magnetanordnungen realisiert sind und dass die Messebenen am Ende der jeweiligen Vormagnetisierungsstrecken in einer einzigen räumlichen Ebene realisiert sind.

9. Verfahren nach einem der Ansprüche 1 bis 7, **dadurch gekennzeichnet, dass** die mindestens zwei Vormagnetisierungsstrecken durch Zerstörungspulse aussendende RF-Spulen realisiert sind und dass die Messebenen am Ende der jeweiligen Vormagnetisierungsstrecken in einer einzigen räumlichen Ebene realisiert sind.

10. Verfahren zur Bestimmung des Durchflusses eines durch ein Messrohr strömenden mehrphasigen Mediums mit einem kernmagnetischen Durchflussmessgerät, mit einer Vormagnetisierungseinrichtungund mit einer Messeinrichtung, wobei die Vormagnetisierungseinrichtung mindestens zwei unterschiedlich lange Vormagnetisierungsstrecken der Längen L₁, L₂, ... realisiert,
**dadurch gekennzeichnet,**
**dass** eine Messeinrichtung verwendet wird, die am Ende einer jeden Vormagnetisierungsstrecke 2D-Tomographie in einer Messrohrquerschnittsebene mit Schichtung in einer z-Richtung realisiert,
**dass** die Messrohrquerschnittsebene in im Verhältnis zum Messrohrdurchmesser dünne Schichten aufgeteilt wird,
**dass** in jeder Schicht kernmagnetische Messungen zur Bestimmung von Messsignalen mit mindestens zwei verschieden langen Vormagnetisierungsstrecken durchgeführt werden,
**dass** aus den Messsignalen die Durchflussgeschwindigkeiten in jeder einzelnen Schicht bestimmt werden und
**dass** aus den Signalverhältnissen der Amplituden der Messsignale in jeder Schicht die T₁-Zeit bestimmt wird.

11. Verfahren nach Anspruch 10, **dadurch gekennzeichnet, dass** mit den absoluten Amplituden der Messsignale die Anteile der einzelnen Phasen im Medium bestimmt werden.

12. Verfahren nach Anspruch 11, **dadurch gekennzeichnet,**
**dass** das Wasser-zu-Flüssigkeitsverhältnis für die unteren Schichten im Messrohr schichtweise von unten nach oben im Messrohr bestimmt wird,
**dass** aus den bestimmten Werten eine Wasser-zu-Flüssigkeitsverhältnis-Kurve in Abhängigkeit der Position der Schicht im Messrohr generiert wird,
**dass** die Kurve ausgehend von dem letzten bestimmten Wert über den gesamten Messrohrquerschnitt extrapoliert wird,
**dass** aus der extrapolierten Kurve die erwarteten Messsignalamplituden für die oberen Schichten im Messrohr berechnet werden und
**dass** der Gas-Volumen-Anteil in den oberen Schichten bestimmt wird aus der Differenz zwischen der erwarteten Messsignalamplitude und der tatsächlich gemessenen Messsignalamplitude.

13. Kernmagnetisches Durchflussmessgerät zur Bestimmung des Durchflusses eines durch ein Messrohr strömenden Mediums, das dazu ausgeführt ist, ein Verfahren nach einem der Ansprüche 1 bis 12 durchzuführen, mit einer Vormagnetisierungseinrichtung und mit einer Messeinrichtung, wobei die Vormagnetisierungseinrichtung mindestens zwei unterschiedlich lange Vormagnetisierungsstrecken der Längen L₁, L₂, ... realisiert,
**dadurch gekennzeichnet,**
**dass** die Messeinrichtung am Ende einer jeden Vormagnetisierungsstrecke 2D-Tomographie in einer Messebene senkrecht zur Messrohrlängsachse realisiert oder 2D-Tomographie in einer Messrohrquerschnittsebene mit Schichtung in einer z-Richtung realisiert.

14. Kernmagnetisches Durchflussmessgerät nach Anspruch 13, **dadurch gekennzeichnet, dass** die unterschiedlichen Längen L₁, L₂, ... der Vormagnetisierungsstrecken durch variable RF-Spulen realisiert sind und dass die Messebenen am Ende einer jeden Vormagnetisierungsstrecke in den Bereich der jeweiligen RF-Spule fallen.

15. Kernmagnetisches Durchflussmessgerät nach Anspruch 13, **dadurch gekennzeichnet, dass** die unterschiedlichen Längen L₁, L₂, ... der Vormagnetisierungsstrecken durch rotierende Magneteinheiten realisiert sind und dass die Messebenen am Ende einer jeden Vormagnetisierungsstrecke in eine einzige räumliche Ebene fallen.

16. Kernmagnetisches Durchflussmessgerät nach Anspruch 13, **dadurch gekennzeichnet, dass** die unterschiedlichen Längen L₁, L₂, ... der Vormagnetisierungsstrecken durch Zerstörungspulse aussendende RF-Spulen realisiert sind und dass die Messebenen am Ende einer jeden Vormagnetisierungsstrecke in eine einzige räumliche Ebene fallen.

## Claims

1. Method for determining the flow of a multi-phase medium flowing through a measuring tube with a nuclear magnetic flowmeter having a pre-magnetization device and a measuring device, wherein the pre-magnetization device implements at least two pre-magnetization sections with different lengths with the lengths L₁, L₂, ..., wherein nuclear magnetic measurement is carried out for determining measuring signals,
**characterized in**
**that** one measuring device is used that implements 2D tomography at the end of each pre-magnetization section in a measuring plane perpendicular to the longitudinal axis of the measuring tube,
**that** the measuring planes are identically divided into voxels,
**that** the dimensions of the voxels are chosen such that only one phase of the medium flows in each voxel,
**that** the flow velocity of the medium is determined in each voxel in each measuring plane,
**that** the average flow velocity of the medium for each voxel over all measuring planes is determined from the determined values of the flow velocity of each corresponding voxel of the individual measuring planes,
**that** the signal ratio of the measuring signals of each corresponding voxel of the different measuring planes to one another is determined and
**that**, with the known values for the lengths L₁, L₂ ... of the pre-magnetization section, the T₁ times in each voxel are determined using the signal ratios.

2. Method according to claim 1, **characterized in that** the respective hydrogen index HI in each voxel is determined with the respective T₁ times and that using the T₁ times and the hydrogen index HI, the different phases of the medium and the sections of the different phases are determined.

3. Method according to claim 2, **characterized in that** the flow rates are determined by integration over the different sections of the medium and multiplication with the respective flow velocities.

4. Method according to any one of claims 1 to 3, **characterized in that** the nuclear magnetic measurement is implemented with a CPMG sequence.

5. Method according to any one of claims 1 to 4, **characterized in that** the velocity of the medium in every voxel in each plane is determined using the "convective decay" method.

6. Method according to any one of claims 1 to 5, **characterized in that** the amplitudes of the measuring signals at time t = 0 are used for determining the signal ratios.

7. Method according to any one of claims 1 to 5, **characterized in that** the temporal course of the measuring signals is used for determining the signal ratio.

8. Method according to any one of claims 1 to 7, **characterized in that** the at least two pre-magnetization sections are implemented by rotating magnetic arrangements and that the measuring planes at the end of each pre-magnetization section are realized in one single spatial plane.

9. Method according to any one of claims 1 to 7, **characterized in that** the at least two pre-magnetization sections are implemented by RF coils transmitting spoil pulses and that the measuring planes at the end of each pre-magnetization section are realized in one single spatial plane.

10. Method for determining the flow of a multi-phase medium flowing through a measuring tube with a nuclear magnetic flowmeter having a pre-magnetization device and a measuring device, wherein the pre-magnetization device implements at least two pre-magnetization sections with different lengths with the lengths L₁, L₂, ...
**characterized in**
**that** a measuring device is used that implements 2D tomography at the end of each pre-magnetization section in the measuring tube cross sectional plane with slicing in the z direction,
**that** the measuring tube cross sectional plane is divided into thin layers in relation to the measuring tube diameter,
**that** nuclear magnetic measurements are carried out in every layer for determining measuring signals with at least two pre-magnetization sections of different lengths,
**that** the flow velocity in each individual layer is determined using the measuring signals and
**that** the T₁ time is determined using the signal ratios of the amplitudes of the measuring signals in each layer.

11. Method according to claim 10, **characterized in that** the portions of the individual phases in the medium are determined using the absolute amplitudes of the measuring signals.

12. Method according to claim 11, **characterized in**
**that** the water to liquid ratio for the lower layers in the measuring tubes are determined layer for layer from bottom to top in the measuring tube,
**that** a water to liquid curve depending on the position of the layer in the measuring tube is generated using the determined values,
**that** the curve is extrapolated based on the last determined value over the entire measuring tube cross section,
**that** the expected measuring signal amplitudes for the upper layers in the measuring tube are calculated from the extrapolated curve and
**that** the gas volume portion in the upper layers is determined using the difference between the expected measuring signal amplitude and the actual measuring signal amplitude.

13. Nuclear magnetic flowmeter for determining the flow of a medium flowing through a measuring tube in particular with a method according to any one of claims 1 to 12 having a pre-magnetization device and a measuring device, wherein the pre-magnetization device implements at least two pre-magnetization sections of differing lengths with the lengths L₁, L₂, ... **characterized in**
**that** the measuring device implements 2D tomography at the end of each pre-magnetization section either in one measuring plane perpendicular to the longitudinal axis of the measuring tube or in the measuring tube cross sectional plane with slicing in the z-direction.

14. Nuclear magnetic flowmeter according to claim 13, **characterized in that** the different lengths L₁, L₂, ... of the pre-magnetization section are implemented by variable RF coils and that the measuring planes at the end of every pre-magnetization section fall in the area of the respective RF coil.

15. Nuclear magnetic flowmeter according to claim 13, **characterized in that** the different lengths L₁, L₂, ... of the pre-magnetization section are implemented by rotating magnetic arrangements and that the measuring planes at the end of each pre-magnetization section are realized in one single spatial plane.

16. Nuclear magnetic flowmeter according to claim 13, **characterized in that** the different lengths L₁, L₂, ... of the pre-magnetization section are implemented by RF coils transmitting spoil pulses and that the measuring planes at the end of each pre-magnetization section are realized in one single spatial plane.

## Revendications

1. Procédé de détermination du débit d'un milieu polyphasique s'écoulant à travers un tube de mesure à l'aide d'un débitmètre magnétique nucléaire, d'un dispositif de prémagnétisation et d'un dispositif de mesure, le dispositif de prémagnétisation réalisant au moins deux sections de prémagnétisation de longueurs différentes L₁, L₂, ..., une mesure magnétique nucléaire étant effectuée pour déterminer des signaux de mesure, **caractérisé en ce que**
un dispositif de mesure est utilisé, qui réalise à l'extrémité de chaque section de prémagnétisation une tomographie 2D dans un plan de mesure perpendiculaire à l'axe longitudinal du tube de mesure,
les plans de mesure sont chacun divisés de manière identique en voxels,
la dimension des voxels est choisie de telle sorte qu'une seule phase du milieu s'écoule dans chaque voxel,
la vitesse d'écoulement du milieu dans chaque voxel est déterminée dans chaque plan de mesure,
la vitesse d'écoulement moyenne du milieu d'un voxel est déterminée dans tous les plans de mesure à partir des valeurs déterminées des vitesses d'écoulement des voxels correspondants des plans de mesure individuels, le rapport des signaux de mesure des voxels correspondants des différents plans de mesure les uns par rapport aux autres est déterminé et
les temps T₁ dans chaque voxel sont déterminés à partir des rapports de signaux avec les valeurs connues des longueurs L₁, L₂, ... des sections de prémagnétisation.

2. Procédé selon la revendication 1, **caractérisé en ce que** l'indice d'hydrogène respectif HI dans chaque voxel est déterminé avec les temps T₁ respectifs et **en ce que** les différentes phases du milieu et les zones des différentes phases sont déterminées sur la base des temps T₁ et des indices d'hydrogène HI.

3. Procédé selon la revendication 2, **caractérisé en ce que** les débits sont déterminés par intégration sur les différentes zones du milieu et par multiplication avec les vitesses d'écoulement correspondantes.

4. Procédé selon l'une des revendications 1 à 3, **caractérisé en ce que** la mesure magnétique nucléaire est effectuée avec une séquence CPMG.

5. Procédé selon l'une des revendications 1 à 4, **caractérisé en ce que** la vitesse du milieu dans chaque voxel à chaque plan est déterminée par la méthode « Convective Decay ».

6. Procédé selon l'une des revendications 1 à 5, **caractérisé en ce que** les amplitudes des signaux de mesure à l'instant t = 0 sont utilisées pour déterminer les rapports de signaux.

7. Procédé selon l'une des revendications 1 à 5, **caractérisé en ce que** la variation des signaux de mesure dans le temps est utilisée pour déterminer les rapports de signaux.

8. Procédé selon l'une des revendications 1 à 7, **caractérisé en ce que** les au moins deux sections de prémagnétisation sont réalisées par des agencements d'aimants rotatifs et **en ce que** les plans de mesure sont réalisés dans un seul plan spatial à l'extrémité des sections de prémagnétisation respectives.

9. Procédé selon l'une des revendications 1 à 7, **caractérisé en ce que** les au moins deux sections de prémagnétisation sont réalisées par des bobines RF émettant des impulsions destructrices et **en ce que** les plans de mesure sont réalisés dans un seul plan spatial à l'extrémité des sections de prémagnétisation respectives.

10. Procédé de détermination du débit d'un milieu polyphasique s'écoulant à travers un tube de mesure à l'aide d'un dispositif de mesure de débit magnétique nucléaire, d'un dispositif de prémagnétisation et d'un dispositif de mesure, le dispositif de prémagnétisation réalisant au moins deux sections de prémagnétisation de longueurs différentes L₁, L₂, ...,
**caractérisé en ce que**
un dispositif de mesure est utilisé, qui réalise une tomographie 2D dans un plan de coupe transversal de tube de mesure avec stratification dans une direction z à l'extrémité de chaque section de prémagnétisation,
le plan de coupe transversale de tube de mesure est divisé en couches minces par rapport au diamètre du tube de mesure,
des mesures magnétiques nucléaires sont effectuées dans chaque couche pour déterminer des signaux de mesure avec au moins deux sections de prémagnétisation de longueurs différentes,
les débits dans chaque couche individuelle sont déterminés à partir des signaux de mesure et
le temps T₁ est déterminé à partir des rapports de signaux des amplitudes des signaux de mesure dans chaque couche.

11. Procédé selon la revendication 10, **caractérisé en ce que** les proportions des phases individuelles dans le milieu sont déterminées avec les amplitudes absolues des signaux de mesure.

12. Procédé selon la revendication 11, **caractérisé en ce que**
le rapport eau/liquide pour les couches inférieures du tube de mesure est déterminé par couches de bas en haut dans le tube de mesure,
une courbe de rapport eau/liquide est générée à partir des valeurs déterminées en fonction de la position de la couche dans le tube de mesure,
la courbe est extrapolée à partir de la dernière valeur déterminée sur toute la section transversale du tube de mesure,
les amplitudes attendues des signaux de mesure pour les couches supérieures du tube de mesure sont calculées à partir de la courbe extrapolée et
la proportion de gaz en volume dans les couches supérieures est déterminée à partir de la différence entre l'amplitude attendue du signal de mesure et l'amplitude réellement mesurée du signal de mesure.

13. Débitmètre magnétique nucléaire destiné à déterminer le débit d'un milieu circulant à travers un tube de mesure, qui est conçu pour mettre en œuvre un procédé selon l'une des revendications 1 à 12, comprenant un dispositif de prémagnétisation et un dispositif de mesure, le dispositif de prémagnétisation réalisant au moins deux sections de prémagnétisation de longueurs différentes L₁, L₂, ...,
**caractérisé en ce que**
le dispositif de mesure réalise la tomographie 2D dans un plan de mesure perpendiculaire à l'axe longitudinal du tube de mesure à l'extrémité de chaque section de prémagnétisation ou réalise la tomographie 2D dans un plan de coupe transversal du tube de mesure avec stratification dans une direction z.

14. Débitmètre magnétique nucléaire selon la revendication 13, **caractérisé en ce que** les différentes longueurs L₁, L₂, ... des sections de prémagnétisation sont réalisées par des bobines RF variables et **en ce que** les plans de mesure à l'extrémité de chaque section de prémagnétisation tombent dans la zone de la bobine RF respective.

15. Débitmètre magnétique nucléaire selon la revendication 13, **caractérisé en ce que** les différentes longueurs L₁, L₂, ... des sections de prémagnétisation sont réalisées par des unités magnétiques rotatives et **en ce que** les plans de mesure tombent dans un seul plan spatial à l'extrémité de chaque section de prémagnétisation.

16. Débitmètre magnétique nucléaire selon la revendication 13, **caractérisé en ce que** les différentes longueurs L₁, L₂, ... des sections de prémagnétisation sont réalisées par des bobines RF émettant des impulsions destructrices et **en ce que** les plans de mesure à l'extrémité de chaque section de prémagnétisation tombent dans un seul plan spatial.
